(19) Europäisches Patentamt
European Patent Office
Office européen des brevets

(11) **EP 3 561 524 A1**

(12) **EUROPÄISCHE PATENTANMELDUNG**

(43) Veröffentlichungstag:
30.10.2019 Patentblatt 2019/44

(51) Int Cl.:
*G01R 15/20* (2006.01)

(21) Anmeldenummer: 18169290.6

(22) Anmeldetag: **25.04.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Hoffmann, Ingolf**
**91074 Herzogenaurach (DE)**
• **Itzke, Alexander**
**90443 Nürnberg (DE)**
• **Weiss, Roland**
**91058 Erlangen (DE)**
• **Chahid, Abderrahim**
**91334 Hemhofen (DE)**

(54) **STROMMESSVORRICHTUNG MIT FLEXIBLER LEITERPLATTE**

(57) Die Erfindung betrifft eine Strommessvorrichtung (1) mit einer Vielzahl an drehsymmetrisch angeordneten Magnetfeldsensoren (3) und einer Trägereinrichtung, auf der die Magnetfeldsensoren (3) angeordnet sind. Die Trägereinrichtung ist eine flexible Leiterplatte (2), die im Zentrum der Magnetfeldsensoren (3) eine erste Aussparung (6) aufweist sowie eine zweite Aussparung (7), die sich von einem Außenrand der flexiblen Leiterplatte (2) bis zu der ersten Aussparung (6) erstreckt. Durch die zweite Aussparung (7) kann die ringförmige Strommessvorrichtung leicht geöffnet und auf kontaktierte Anschlüsse aufgebracht werden.

FIG 1

EP 3 561 524 A1

**Beschreibung**

Die vorliegende Erfindung betrifft eine Strommessvorrichtung mit einer Vielzahl an rotationssymmetrisch angeordneten Magnetfeldsensoren und einer Trägereinrichtung, auf der die Magnetfeldsensoren angeordnet sind.

In leistungselektronischen Geräten besteht häufig die Aufgabe der Strommessung an Bauteilen, welche sehr unterschiedliche zeitliche Stromformen, z.B. Gleichströme, denen Wechselströme überlagert sind, führen. Oftmals sind diese Bauteile darüber hinaus unzugänglich verbaut, wie beispielsweise Kondensatoren einer Kondensatorbank. Die Stromsensoren sollen dabei durch ihre Anordnung weder das Messsignal noch den mechanischen Aufbau des leistungselektronischen Geräts in nennenswerten Umfang beeinflussen. Dies gilt selbstverständlich auch für andere Anordnungen, die einen geringeren elektrischen Leistungsverbrauch besitzen.

Soll eine Messung der Stromverteilung beispielsweise in einer verschienten Kondensatorbank vorgenommen werden, so kann dies vielfach nur mit begrenzter Qualität geschehen. Um all den Anforderungen an die Strommessung in leistungselektronischen Geräten gerecht zu werden, sollte der Stromsensor folgende Eigenschaften erfüllen:

- gute Genauigkeit (Fehler < 0,5 Prozent), vergleichbar mit einer Rogowski-Spule oder einem Stromwandler,
- guter Frequenzgang (von Gleichstrom bis 100kHz, in Sonderfällen bis 1MHz), vergleichbar mit einem Shunt,
- potentialfrei (Isolationsfestigkeit je nach Spannungsklasse), vergleichbar mit einer Rogowski-Spule oder mit einem Stromwandler,
- sehr geringe Fremdfeldempfindlichkeit, vergleichbar mit einem Shunt oder mit einer Rogowski-Spule, und
- guter mechanischer Formfaktor (klein und wenn möglich flexibel), vergleichbar mit einer Rogowski-Spule.

Bisher wurden zur temporären Strommessung im Inneren von leistungselektronischen Geräten flexible Rogowski-Spulen eingesetzt. Diese haben jedoch den Nachteil, dass der Gleichstrom beziehungsweise der niederfrequente Anteil (<2Hz) des Signals nicht erfasst werden kann. Mit Shunts kann zwar Gleichstrom beziehungsweise niederfrequenter Strom erfasst werden, jedoch besteht bei diesen Shunts der Nachteil, dass durch die erforderliche Anschlussmechanik eine Beeinflussung des Messsignals nicht ausgeschlossen werden kann. Ein weiterer Nachteil der Shunt-basierten Messung des Stroms ist die Potentialbehaftung des elektrischen Messsignales. Dies erfordert einen erhöhten Aufwand bei der Messtechnik aufgrund der notwendigen galvanischen Trennung. Bisher wurde das Problem in der Gesamtheit der Anforderungen nicht vollständig zufriedenstellend gelöst.

Zirkulare Anordnungen von Magnetfeldsensoren sind beispielsweise aus dem Artikel "Crosstalk in Circular Arrays of Magnetic Sensors for Current Measurement", R. Weiss, R. Makuch, A. Itzke, R. Weigel, IEEE Transactions on Industrial Electronics 64(6), 4903-4909, Juni 2017 für die galvanisch getrennte Gleichstrommessung bekannt. Diese Anordnungen zeichnen sich durch niedrigen Leistungsverbrauch, hohe Sensitivität und mechanische Flexibilität aus.

Darüber hinaus ist in dem Artikel "Current measurement of flat conductors with a circular array of magnetic sensors", R. Weiss, A. Itzke, R. Weigel, IEEE Second International Conference on DC Microgrids (ICDCM), 2017, 166-170 eine Strommessvorrichtung für Mikronetze zur Gleichstromversorgung bekannt. Es wird auch hier ein zirkularer Sensor mit sechs gleichen Magnetfeldsensoren bereitgestellt. Dieser "Open-Loop-DC-Sensor" besitzt eine hohe mechanische Flexibilität und einen geringen Eigenverbrauch.

Die Druckschrift WO 2016/156392 A1 beschreibt eine verbesserte Strommessvorrichtung zur galvanisch entkoppelten Messung von hohen Strömen durch einen Stromleiter auf Basis des gleichen physikalischen Grundprinzips. Hierzu wird um den Stromleiter eine Mehrzahl von Magnetfeldsensoren angeordnet. Ferner umfasst die Strommessvorrichtung eine Kompensationsspule, die die Magnetfeldsensoren umschließt, und in der ein Kompensationsstrom eingestellt werden kann. Durch Einregeln des Kompensationsstroms durch die Kompensationsspule können sich das Magnetfeld aufgrund des zu messenden elektrischen Stroms durch den Stromleiter und das Magnetfeld aufgrund des elektrischen Kompensationsstroms durch die Kompensationsspule weitestgehend kompensieren. Dies ermöglicht eine sehr präzise und störungsfreie Messung von hohen elektrischen Strömen über einen großen Dynamikbereich hinweg.

Die Aufgabe der vorliegenden Erfindung besteht darin, eine hochqualitative Strommessvorrichtung insbesondere für niederfrequente Messungen bereitzustellen, die in der Anwendung den mechanischen Aufbau eines leistungselektronischen Geräts kaum beeinflusst.

Erfindungsgemäß wird diese Aufgabe durch einen Strommessvorrichtung nach Anspruch 1 gelöst. Vorteilhafte Weiterbildungen der Erfindung ergeben sich aus den Unteransprüchen.

Erfindungsgemäß wird demnach bereitgestellte eine Strommessvorrichtung mit

- einer Vielzahl an rotationssymmetrisch angeordneten Magnetfeldsensoren und
- einer Trägereinrichtung, auf der die Magnetfeldsensoren angeordnet sind, wobei
- die Trägereinrichtung eine flexible Leiterplatte ist,
- die flexible Leiterplatte im Zentrum der Magnetfeldsensoren eine erste Aussparung aufweist und

- die flexible Leiterplatte eine zweite Aussparung aufweist, die sich von einem Außenrand der flexiblen Leiterplatte bis zu der ersten Aussparung erstreckt.

Die Strommessvorrichtung soll insbesondere für Gleichströme und/oder niederfrequente Wechselströme nutzbar sein. Dazu besitzt sie mehrere rotationssymmetrisch angeordnete Magnetfeldsensoren. Diese rotationssymmetrisch angeordneten Magnetfeldsensoren können um einen Stromleiter angeordnet werden, in dem der Strom gemessen wird. Somit ist die Anordnung durch Drehung um das Zentrum um einen vorbestimmten Winkel in sich überführbar. Die Magnetfeldsensoren befinden sich dann zur Strommessung symmetrisch um den Stromleiter herum. Die Magnetfeldsensoren sind dabei auf einer Trägereinrichtung angeordnet. Sie werden auf dieser Trägereinrichtung, die beispielsweise als Leiterplatte ausgebildet sein kann, in der Regel nicht nur gehalten, sondern auch elektrisch kontaktiert. Die Trägereinrichtung dient also meist auch zur Stromversorgung der Magnetfeldsensoren beziehungsweise zur Signalführung.

Speziell ist nun die Trägereinrichtung als eine flexible Leiterplatte ausgebildet. Gegebenenfalls können auch das Gehäuse und gegebenenfalls der Verguss der Elektronikbaugruppe mechanisch flexibel ausgeführt sein. Dies bedeutet, dass die Strommessvorrichtung biegbar beziehungsweise in sich verwindbar ausgebildet ist. Somit kann die Strommessvorrichtung auch an Orten platziert werden, an denen übliche starre Strommessvorrichtungen beziehungsweise Leiterplatten nicht angeordnet beziehungsweise befestigt werden können. Dies ist insbesondere bei schwer zugänglichen Stromleitern der Fall, in denen der Strom gemessen werden soll.

Die flexible Leiterplatte besitzt im Zentrum der rotationssymmetrisch angeordneten Magnetfeldsensoren, also in der Mitte der Magnetfeldsensoranordnung eine erste Aussparung. Durch diese erste Aussparung kann ein Stromleiter geführt werden, dessen Strom gemessen werden soll. Des Weiteren besitzt die flexible Leiterplatte eine zweite Aussparung, die von der ersten Aussparung bis nach außen zum Außenrand der flexiblen Leiterplatte führt. Dies bedeutet, dass die flexible Leiterplatte durch die zweite Aussparung aufgetrennt und damit aufbiegbar ist. Durch Aufbiegen der flexiblen Leiterplatte an der zweiten Aussparung lässt sich die Strommessvorrichtung somit über einen Stromleiter ziehen beziehungsweise stecken. Dabei sollte die zweite Aussparung so dimensioniert sein, dass sie dünner beziehungsweise schmäler als beispielsweise der Durchmesser des Stromleiters, in dem der Strom gemessen wird, ist. Durch entsprechende Rückstellkraft kann sich die flexible Leiterplatte nach dem Aufbiegen wieder in ihre Ausgangsstellung zurück biegen, wodurch sie aufgrund der kleiner dimensionierten zweiten Aussparung an dem Stromleiter gehalten wird. Dadurch ist in der Regel ein ausreichender Sitz der Strommessvorrichtung an dem zu vermessenden Stromleiter gegeben. Damit kann eine hochpräzise Strommessung an dem beziehungsweise in dem Stromleiter durchgeführt werden.

In einer bevorzugten Ausgestaltung ist die flexible Leiterplatte ggf. mit flexiblem Gehäuse ringförmig ausgestaltet. Ringförmig bedeutet hier, dass es sich um eine offene Ringform handelt, da ja die zweite Aussparung den geschlossenen Ring unterbricht. Demnach ist die flexible Leiterplatte zumindest im Wesentlichen ringförmig. Die Ringform kann beispielsweise die Gestalt eines Kreisrings bedeuten. Alternativ kann die flexible Leiterplatte aber auch die Gestalt eines Polygonrings haben. Dabei könnte beispielsweise an jedem Eck oder an jedem Schenkel einer der Magnetfeldsensoren angeordnet sein.

Weiterhin ist bevorzugt, wenn die zweite Aussparung ein in der ringförmigen, flexiblen Leiterplatte radial verlaufender Spalt ist. Der Spalt hat maximal diejenige Breite, die dem Abstand zweier benachbarter Magnetfeldsensoren entspricht. Durch die Drehsymmetrie sind die Abstände zwischen benachbarten Magnetfeldsensoren am Umfang überall gleich. Um die Drehsymmetrie zu wahren, müssen die Magnetfeldsensoren im Ausgangszustand der flexiblen Leiterplatte (d.h. im ungebogenen Zustand) am Umfang gleich verteilt sein. Dies wäre nicht gewahrt, wenn der Spalt breiter als dieser Abstand der Magnetfeldsensoren ist. Der radial verlaufende Spalt kann auch sehr eng sein und lediglich einem Schnitt durch die ringförmige, flexible Leiterplatte entsprechen. Die zweite Aussparung hat lediglich die Funktion, dass die flexible Leiterplatte aufgebogen und der zu vermessende Stromleiter in die erste Aussparung eingefügt werden kann.

In einer weiteren bevorzugten Ausgestaltung ist die ringförmig, flexible Leiterplatte am gesamten Umfang mit Ausnahme der zweiten Aussparung von einer Ringspule zur Kompensation eines konzentrisch mit der Leiterplatte verlaufenden Magnetfelds umgeben. Die Ringspule umläuft also die gesamte ringförmige Leiterplatte mit Ausnahme des gesamten Spalts oder eines Teils des Spalts beziehungsweise der zweiten Aussparung. Dies bedeutet, dass die ringförmige Spule ebenfalls offen ist beziehungsweise zu öffnen ist, sodass der zu vermessende Stromleiter ins Innere der Ringspule gebracht werden kann. Die Ringspule zur Kompensation eines von dem Stromleiter hervorgerufenen Magnetfelds besitzt etwa die Gestalt eines Torus. Dabei verläuft jede Windung angenähert entlang eines radialen Schnitts durch den Tonus. Die Ringspule beziehungsweise der Torus ist an der Stelle der zweiten Aussparung geöffnet beziehungsweise kann dort geöffnet werden. Aufgrund des Kompensationsprinzips muss unabhängig von dem elektrischen Strom durch den Stromleiter durch die Magnetfeldsensoren jeweils nur ein relativ geringes Magnetfeld erfasst werden. Daher ist die Strommessung über einen sehr großen Messbereich hinweg möglich.

Im Gegensatz zu konventionellen Strommesswandlern mit einem Magnetfeldkonzentrator ist bei dem erfindungsgemäßen Messprinzip kein Flusskreis aus einem ferro- oder ferrimagnetischen Material erforderlich. Somit sind auch keine Messfehler aufgrund der magnetischen Hysterese in dem Flusskonzentrator zu erwarten. Darüber hinaus sinkt auch das Gewicht der Strommessvorrichtung im Vergleich zu konventionellen Strommessvorrichtungen mit Flusskonzentratoren.

Aufgrund der Verwendung von mehreren Magnetfeldsensoren um den Stromleiter herum gleichen sich auch gegebenenfalls statistische Offset-Fehler besser aus, wodurch die Genauigkeit der Strommessvorrichtung zusätzlich gesteigert werden kann. Da sich im Inneren der Kompensationsspule bis auf die Magnetfeldsensoren in der Regel nur dia- oder paramagnetische Materialien befinden, weist die Kompensationsspule auch eine sehr geringe Induktivität auf. Dies führt auch zu einer sehr großen Grenzfrequenz einer Kompensationsregelung für das Einstellen des Stroms durch die Kompensationsspule. Für die Treiber des Stroms durch die Kompensationsspule ist somit ein relativ einfacher Aufbau möglich. Schließlich weist der geschilderte Aufbau der Strommessvorrichtung eine sehr geringe Empfindlichkeit gegenüber Fremd- und Störfeldern auf.

In einer Ausgestaltungsform kann die flexible Leiterplatte gegebenenfalls einschließlich flexiblem Gehäuse und/oder Verguss scheibenringförmig oder in einer anderen geeigneten Geometrie gebildet sein. Ein derartiger Scheibenring lässt sich einfach aus einem Plattenmaterial gewinnen. Beispielsweise kann dies durch Ausstanzen oder Ausschneiden, aber auch durch Sägen erfolgen.

In einer alternativen Ausgestaltung gegenüber der Scheibenringform besitzt die flexible Leiterplatte gegebenenfalls einschließlich eines flexiblen Gehäuses eine zylindermantelförmige Gestalt oder eine andere geeignete Geometrie. Dies bedeutet beispielsweise, dass die Leiterplatte zunächst in Form eines Streifens vorliegt und anschließend an ihren Enden zusammengebogen wird, sodass sich ein nahezu geschlossener Hohlzylinder beziehungsweise Zylindermantel ergibt. Die Magnetfeldsensoren können dann an der Innenseite oder der Außenseite des Zylindermantels beziehungsweise der Leiterplatte angeordnet werden.

In einer weiteren Ausgestaltung kann vorgesehen sein, dass die Strommessvorrichtung eine Kompensationselektronik auf oder an der flexiblen Leiterplatte besitzt. Mit dieser Kompensationselektronik lässt sich derjenige Strom erzeugen und messen, der zur Kompensation des von dem zu messenden Strom hervorgerufenen Magnetfelds dient. Damit kann die flexible Leiterplatte nicht nur als Träger der Magnetfeldsensoren, sondern auch als Träger der Kompensationselektronik dienen.

Des Weiteren kann vorgesehen sein, dass die flexible Leiterplatte oder die Ringspule zumindest teilweise von einer elastischen Vergussmasse oder einem flexiblen Gehäuse umgeben ist. Durch diese elastische Vergussmasse oder das flexible Gehäuse wird die Strommessvorrichtung mechanisch robuster. Darüber hinaus bewirken die Vergussmasse oder das Gehäuse auch einen Schutz gegen äußere Einflüsse.

Insgesamt kann die Strommessvorrichtung als einstückige Baugruppe realisiert sein. Dabei können sämtliche Bauelemente wie Leiterplatte mit Magnetfeldsensoren, Ringspule, Kompensationselektronik, Gehäuse und dergleichen so aneinander gefügt sein, dass sämtliche Komponenten ein einstückiges Modul beziehungsweise eine einstückige Baugruppe bilden. Dies erleichtert die Montage beziehungsweise Handhabung der Strommessvorrichtung.

Des Weiteren kann vorgesehen sein, dass auf der Trägereinrichtung 6 bis 12 Magnetfeldsensoren angeordnet sind. Prinzipiell sind natürlich auch mehr oder weniger Magnetfeldsensoren auf der Trägereinrichtung möglich. Für die Abdeckung des Ringbereichs genügen häufig bereits 6 Magnetfeldsensoren, die am Umfang gleich verteilt angeordnet sind. Bei weniger als 6 Sensoren steigt die Ungenauigkeit verhältnismäßig stark an. Mehr als 12 Magnetfeldsensoren am Umfang verteilt sind im Hinblick auf die Genauigkeit meist nicht notwendig. Bei mehr als 12 Magnetfeldsensoren steigt der Mess- beziehungsweise Rechenaufwand ungebührlich an.

Die vorliegende Erfindung wird nun anhand der beigefügten Zeichnungen näher erläutert, in denen zeigen:

FIG 1   eine Strommessvorrichtung mit flexibler Leiterplatte und Spalt;

FIG 2   einen Kondensator mit einem Anschluss, auf dem eine Strommessvorrichtung gemäß FIG 1 platziert ist in einer Seitenansicht;

FIG 3   den Kondensator mit Strommessvorrichtung von FIG 2 in Draufsicht;

FIG 4   eine Strommessvorrichtung mit scheibenringförmiger Leiterplatte und Ringspule in Draufsicht;

FIG 5   die Strommessvorrichtung von FIG 4 in einer Seitenansicht;

FIG 6   eine Strommessvorrichtung mit zylindermantelförmiger Leiterplatte und Ringspule in Draufsicht; und

FIG 7   die Strommessvorrichtung von FIG 6 in einer Seitenansicht.

Die nachfolgend näher geschilderten Ausführungsbeispiele stellen bevorzugte Ausführungsformen der vorliegenden Erfindung dar. Speziell zeigen die folgenden Ausführungsbeispiele, dass die Anforderungen, die bei der Strommessung im Inneren von leistungselektronischen Systemen bestehen, im Vergleich zum Stand der Technik in ihrer Gesamtheit besser erfüllt werden können. Zu diesen Anforderungen gehört neben hoher Genauigkeit, gutem Frequenzgang, Potentialfreiheit und sehr geringer Fremdfeldempfindlichkeit ein guter mechanischer Formfaktor. Insbesondere sind die gezeigten Strommessvorrichtungen derart flexibel, dass sie zerstörungsfrei um Stromleiter gelegt werden können, ohne dass Kontakte geöffnet werden müssen.

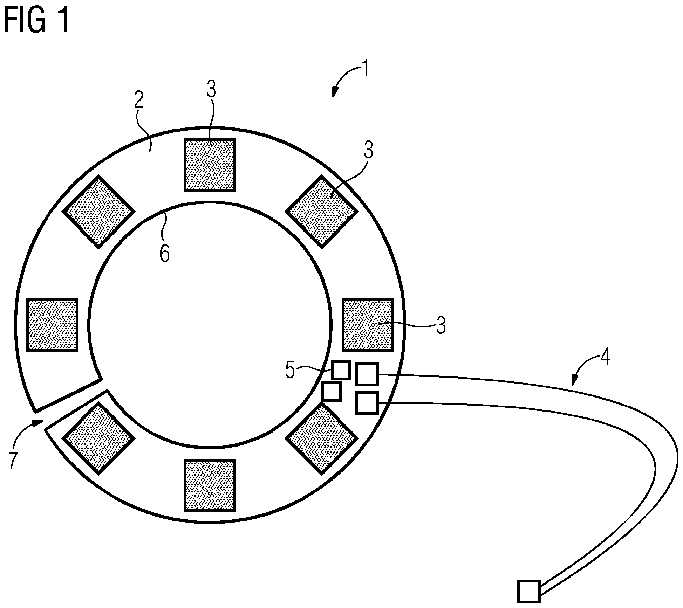

Entsprechend dem Beispiel von FIG 1 wird eine Strommessvorrichtung 1 bereitgestellt, die eine flexible, ringförmige Leiterplatte 2 aufweist. Auf der Leiterplatte 2 befinden sich rotationssymmetrisch angeordnet Magnetfeldsensoren 3. Diese Magnetfeldsensoren 3 detektieren vorzugsweise ein Magnetfeld, dessen Feldlinien ebenso ringförmig verlaufen wie die Leiterplatte 2. Dies bedeutet, dass das zu detektierende Magnetfeld koaxial mit der flexiblen Leiterplatte 2 als Trägereinrichtung der rotationssymmetrisch angeordneten Magnetfeldsensoren 3 ausgerichtet sein sollte.

Die flexible Leiterplatte 2 dient nicht nur als Trägereinrichtung, sondern auch zur Stromversorgung beziehungsweise zum Führen der Sensorsignale. Dazu besitzt die Leiterplatte beispielsweise eine Anschlussschnittstelle 4, die in FIG 1 durch ein Kabel symbolisiert ist. Gegebenenfalls befindet sich auf der Leiterplatte 2 auch eine Auswerteelektronik 5, um beispielsweise die Einzelsignale der Magnetfeldsensoren 3 zu kombinieren beziehungsweise zu summieren.

Darüber hinaus besitzt die Trägereinrichtung beziehungsweise die flexible Leiterplatte 2 im Inneren, d.h. im Zentrum der rotationssymmetrischen Anordnung der Magnetfeldsensoren 3 eine erste Aussparung 6. Diese Aussparung ist im vorliegenden Beispiel kreisförmig und dient dazu, dass ein Stromleiter hindurchgeführt wird, der den zu messenden Strom führt. Auch wenn im vorliegenden Beispiel die erste Aussparung kreisförmig ist, kann sie auch beispielsweise polygonartig, rechteckig, oval oder dergleichen sein. Das Gleiche gilt für den Außenumfang der flexiblen Leiterplatte 2.

Darüber hinaus weist die flexible Leiterplatte 2 erfindungsgemäß eine zweite Aussparung 7 auf. Im vorliegenden Fall handelt es sich um einen Spalt, der den Ring der Leiterplatte 2 teilt. Der Spalt kann auch breiter oder schmäler gewählt werden. Jedenfalls sollte er schmäler als der Abstand der beiden benachbarten Magnetfeldsensoren 3 sein. Durch den Spalt und aufgrund der Flexibilität der Leiterplatte 2 lässt sich diese Sensoranordnung aufbiegen und um einen Stromleiter führen. Durch die Rückstellkraft der flexiblen Leiterplatte geht diese in ihre ebene Ausgangsposition zurück und umschließt den Stromleiter dann formschlüssig. Dabei sollte die Spaltbreite auf alle Fälle auch kleiner als der Durchmesser des Stromleiters sein.

Die Anzahl der Magnetfeldsensoren 3 der Strommessvorrichtung im Beispiel von FIG 1 beträgt 8. Diese Anzahl der Magnetfeldsensoren 3 kann aber auch größer oder kleiner gewählt werden. Vorzugsweise liegt diese Anzahl zwischen 6 und 12.

Beispielsweise handelt es sich bei den Magnetfeldsensoren 3 um magneto-resistive Magnetfeldsensoren. Es können aber auch andere Messprinzipien, wie etwa der Hall-Effekt genutzt werden.

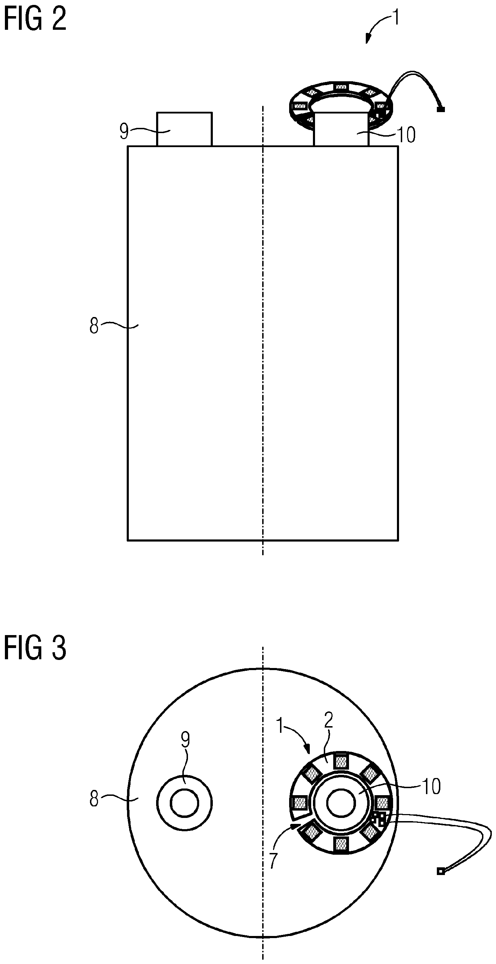

Durch eine Stromsensorbaugruppe als Strommessvorrichtung, die auf einer Anordnung von Magnetfeldsensoren, welche rotationssymmetrisch auf einer flexiblen Leiterplatte aufgebracht sind, beruht, besteht die Möglichkeit, diese Stromsensorbaugruppe um den stromführenden Anschluss eines Bauteils (z.B. Kondensator) mechanisch vorteilhaft anzuordnen. FIG 2 zeigt einen derartigen Kondensator 8 mit zwei Anschlüssen 9, 10 in der Seitenansicht. FIG 3 zeigt diesen Kondensator 8 in der Draufsicht. Der Kondensator 8 ist hier zylinderförmig ausgebildet und besitzt an seiner Stirnseite die zwei Anschlüsse 9 und 10. Diese sind hier ebenfalls zylinderförmig ausgebildet und stehen sich auf der Stirnseite des Kondensators 8 diametral gegenüber. Um einen Anschluss 10 dieser beiden Anschlüsse 9, 10 ist die Strommessvorrichtung angeordnet. Speziell umgibt die ringförmige Leiterplatte 2 den zylindrischen Anschluss 10.

Der Kondensator 8 kann Teil einer Kondensatorbank sein. Im angeschlossenen Zustand sind die entsprechenden Anschlüsse beispielsweise verschient. Auch in diesem Zustand lässt sich die Strommessvorrichtung 1 leicht auf den Anschlüssen 9, 10 anbringen, da die Leiterplatte 2 die zweite Aussparung beziehungsweise den Spalt 7 besitzt.

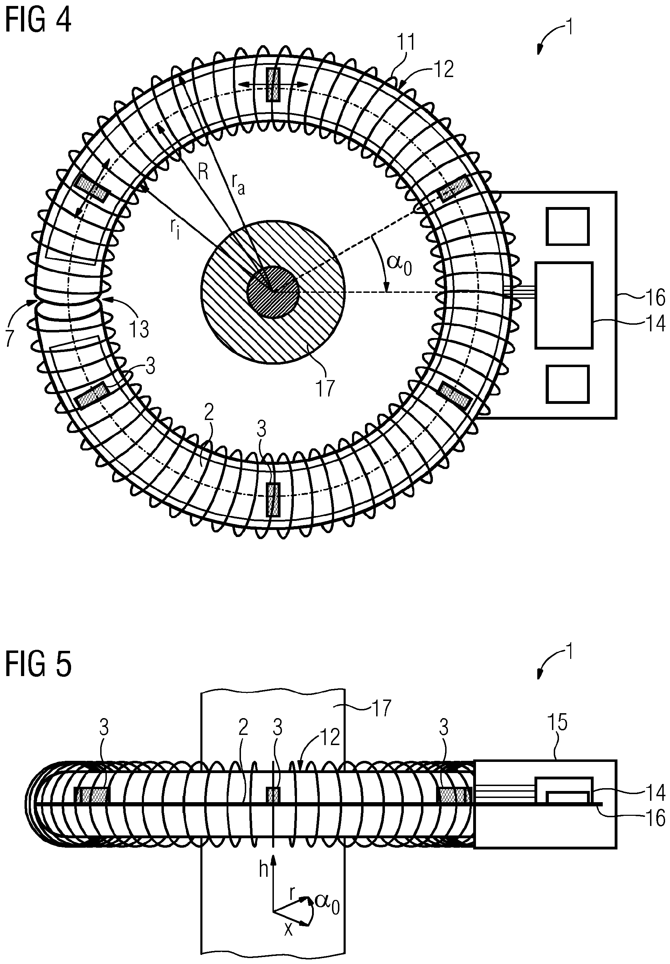

In einem weiteren Ausführungsbeispiel gemäß FIG 4 ist die Anordnung der Magnetfeldsensoren 3 auf der flexiblen Leiterplatte 2 mit einer Ringspule 11 zur Realisierung eines so genannten "Closed Loop"-Stromsensors nach dem Durchflutungsgesetz, ähnlich wie in der Druckschrift WO 2016/156392 A1 beschrieben, ergänzt.

Die scheibenringförmige Leiterplatte 2 besitzt einen mittleren Radius R. Rotationssymmetrisch sind hier sechs Magnetfeldsensoren 3 auf der Leiterplatte 2 angeordnet. Sie sind zueinander in einem Winkel von $2\alpha_0$ angeordnet. Die Leiterplatte 2 ist hier vollständig von einem flexiblen Gehäuse 12 beziehungsweise einem elastischen Verguss umgeben. Dieses Gehäuse 12 besitzt einen Innenradius $r_i$ und einen Außenradius $r_a$. Der Innenradius $r_i$ ist kleiner als derjenige der Leiterplatte 2 und der Außenradius $r_a$ ist größer als derjenige der Leiterplatte 2. Die Ringspule 11 umgibt hier das Gehäuse 12. Alternativ kann die Ringspule auch innerhalb des Gehäuses 12 oder innerhalb der entsprechend flexiblen Vergussmasse angeordnet sein.

Die torusförmige Strommessvorrichtung 1 besitzt eine Öffnung 13. An dieser Öffnung 13 ist nicht nur die Leiterplatte 2 durch den Spalt 7 aufgetrennt, sondern auch das Gehäuse 12 sowie die Ringspule 11. An der Öffnung 13 kann somit die gesamte Strommessvorrichtung 1 aufgrund der flexiblen Materialien geöffnet beziehungsweise aufgebogen werden. Aufgrund der eigenen Elastizität geht die Anordnung, sobald keine Kraft mehr auf sie ausgeübt wird, selbstständig in ihre Ausgangsstellung zurück. In dieser Stellung stehen sich die beiden Enden der Strommessvorrichtung 1 gegenüber.

Die Strommessvorrichtung 1 besitzt hier außerdem eine Kompensationselektronik 14. Diese kann ein eigenes Gehäuse 15 aufweisen (vergleiche FIG 5). Außerdem kann sich die Kompensationselektronik 14 auf einer Leiterplatte 16 befinden, welche vorzugsweise einteilig mit der flexiblen Leiterplatte 12 gebildet ist.

Die Kompensationselektronik 14 dient beispielsweise zur Erzeugung und Messung des Kompensationsstroms, welcher notwendig ist, um ein Magnetfeld eines im Inneren der torusförmigen Strommessvorrichtung 1 befindlichen Stromleiters 17 zu kompensieren. Außerdem kann hier analog oder digital eine gewichtete Summe der Sensorausgangsspannungen berechnet werden, welche als Eingangsgröße für einen Kompensationsregler dient.

Während FIG 4 die Strommessvorrichtung 1 in einer Draufsicht darstellt, gibt FIG 5 die Strommessvorrichtung 1 in einer Seitenansicht wieder. Das skizzierte Koordinatensystem mit den Variablen h, x, r, $\alpha_0$ deutet den rotationssymmetrischen Aufbau der eigentlichen Strommessvorrichtung 1 (ohne Kompensationselektronik 14) an. Insbesondere sind in FIG 5 die ebene Gestalt der flexiblen Leiterplatte 2 sowie die darauf platzierten Magnetfeldsensoren 3 zu erkennen. Ebenso kann die torusförmige Gestalt des flexiblen Gehäuses 12 beziehungsweise der elastischen Vergussmasse in der FIG 5 erkannt werden. Hinsichtlich der übrigen Elemente wird auf die Beschreibung von FIG 4 verwiesen.

Die auf der flexiblen Leiterplatte 2 aufgebaute Elektronik einschließlich der Ringspule 11 kann über den Verguss mit der elastischen Vergussmasse oder über das mechanisch flexible, z.B. schlauchartige Gehäuse 12 vor Umwelteinflüssen wie z.B. Feuchtigkeit geschützt und vom stromführenden Leiter 17 elektrisch isoliert werden. Darüber hinaus erlaubt die Öffnung 13 ein temporäres Öffnen der Anordnung zum Einbringen der Strommessvorrichtung 1 in einen bereits geschlossenen Kreis (z.B. geschlossener Stromkreis). Dadurch wird ein geometrisch offener und mechanisch flexibler Kompensationsstromwandler beziehungsweise eine Stromsensorbaugruppe nach dem "Closed Loop"- oder "Zero Flux"-Prinzip geschaffen.

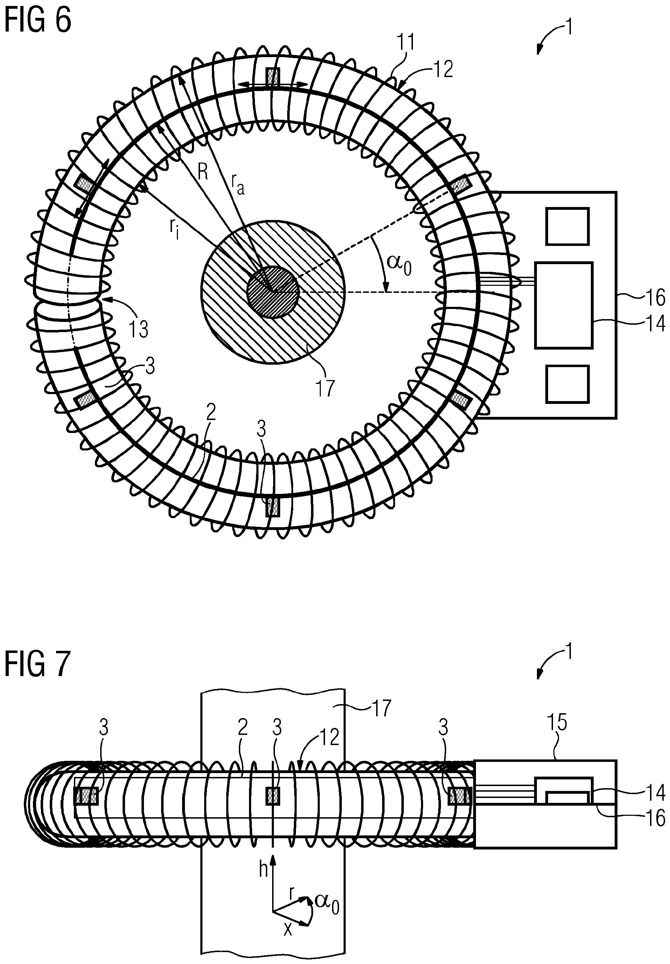

Die FIG 6 und 7 zeigen in Draufsicht und Seitenansicht eine alternative Ausführungsform zu der Ausgestaltung der Strommessvorrichtung 1 gemäß den FIG 4 und 5. Einziger Unterschied ist, dass für den mechanisch flexiblen Kompensationsstromwandler nach dem Prinzip des Durchflutungsgesetzes beziehungsweise des Kelvin-Stokes Theorems die flexible Leiterplatte 2 im Vergleich zu dem vorhergehenden Ausführungsbeispiel um 90 Grad gekippt ist. Dies bedeutet, dass die Leiterplatte 2 beispielsweise aus einem flexiblen Leiterplattenstreifen gebildet ist und kreisförmig mit einem Radius R um den stromführenden Leiter 17 beziehungsweise das Zentrum der Strommessvorrichtung 1 gebogen ist. In der Seitenansicht von FIG 7 ist die flexible Leiterplatte 2 ebenfalls in der gekippten Stellung dargestellt.

Wie bereits erwähnt, basiert die Grundanordnung der Strommessvorrichtung 1 auf der diskreten Realisierung des Durchflutungsgesetzes beziehungsweise des Satzes von Kelvin-Stokes. Das allgemeine Durchflutungsgesetz lautet:

$$J + \frac{dD}{dt} = rot H$$

Neben den Sensorelementen 3 können sich also auch die Summationsschaltung und die entsprechenden Anschlüsse auf der Baugruppe befinden. Alternativ kann die Summationsschaltung auch auf einer weiteren Baugruppe aufgebaut werden. Wird, wie in den FIG 4 bis 7 dargestellt wurde, ein "Closed Loop Sensor" realisiert, muss noch die Kompensationselektronik auf einer weiteren Baugruppe realisiert werden. Gegebenenfalls befindet sich die Kompensationselektronik aber auch auf der Sensorbaugruppe oder der Baugruppe mit der Summationsschaltung. Optional können sämtliche Bauelemente aber auch zu einer einzigen Baugruppe zusammengefasst sein.

Wie bereits erwähnt wurde, kann bei Verwendung von 6 bis 12 Sensoren eine Messung, die von Fremdfeldern weitestgehend unabhängig ist, erreicht werden. Auch die Geometrie und Position des Leiters führt bei hinreichend großer Zahl von Sensoren zu keinen relevanten Messfehlern der Anordnung.

Wie FIG 4 zeigt, können die genannten Baugruppen beispielsweise um die Anschlüsse einzelner Kondensatoren einer Kondensatorbank positioniert werden. Dadurch ist es möglich, den Strom an jedem Kondensator zu messen. Weiterhin kann mit diesem System eine Strommessung an Geometrien erfolgen, wie z.B. DC-Stromschienen in Schranksystemen, ohne diese mechanisch zu unterbrechen.

Generell ist ein geometrisch offener und mechanisch flexibler Kompensationsstromwandler, der auf der diskreten Realisierung des Kelvin-Stokes Theorems beruht, durch die Erfindung realisiert. Dadurch kann völlig auf ferromagnetische beziehungsweise ferrimagnetische Materialien im Messkreis verzichtet werden. Hiermit lassen sich auch die Nachteile dieser Materialien, wie Nicht-Linearität, Hysterese, geringe zeitliche Dynamik et cetera vermeiden. Ein weiterer Vorteil des beschriebenen Systems ist der geringe Energiebedarf im Vergleich zu konventionellen Lösungen.

Bezugszeichenliste

| | |
|---|---|
| 1 | Strommessvorrichtung |
| 2 | Leiterplatte |
| 3 | Magnetfeldsensor |
| 4 | Anschlussschnittstelle |
| 5 | Auswerteelektronik |

| | |
|---|---|
| 6 | Aussparung |
| 7 | Aussparung |
| 8 | Kondensator |
| 9 | Anschluss |
| 10 | Anschluss |
| 11 | Ringspule |
| 12 | Gehäuse |
| 13 | Öffnung |
| 14 | Kompensationselektronik |
| 15 | Gehäuse |
| 16 | Leiterplatte |
| 17 | Stromleiter |
| R | mittlerer Radius |
| $r_i$ | Innenradius |
| $r_a$ | Außenradius |

**Patentansprüche**

1. Strommessvorrichtung (1) mit

   - einer Vielzahl an drehsymmetrisch angeordneten Magnetfeldsensoren (3) und
   - einer Trägereinrichtung, auf der die Magnetfeldsensoren (3) angeordnet sind,

   **dadurch gekennzeichnet, dass**

   - die Trägereinrichtung eine flexible Leiterplatte (2, 16) ist,
   - die flexible Leiterplatte (2, 16) im Zentrum der Magnetfeldsensoren (3) eine erste Aussparung (6) aufweist und
   - die flexible Leiterplatte (2, 16) eine zweite Aussparung (7) aufweist, die sich von einem Außenrand der flexiblen Leiterplatte (2, 16) bis zu der ersten Aussparung (6) erstreckt.

2. Strommessvorrichtung (1) nach Anspruch 1, wobei die flexible Leiterplatte (2, 16) ringförmig ausgestaltet ist.

3. Strommessvorrichtung (1) nach Anspruch 2, wobei die zweite Aussparung (7) ein in der ringförmigen, flexiblen Leiterplatte (2, 16) radial verlaufender Spalt ist.

4. Strommessvorrichtung (1) nach einem der vorhergehenden Ansprüche, wobei die flexible Leiterplatte (2, 16) oder die Ringspule (11) zumindest teilweise von einer elastischen Vergussmasse oder einem flexiblen Gehäuse (12) umgeben ist.

5. Strommessvorrichtung (1) nach einem der Ansprüche 2 bis 4, wobei die ringförmig, flexible Leiterplatte (2, 16) am gesamten Umfang mit Ausnahme der zweiten Aussparung (7) von einer Ringspule (11) zur Kompensation eines konzentrisch mit der Leiterplatte (2, 16) verlaufenden Magnetfelds umgeben ist.

6. Strommessvorrichtung nach einem der vorhergehenden Ansprüche, wobei die flexible Leiterplatte (2, 16) scheibenringförmig ausgestaltet ist.

7. Strommessvorrichtung (1) nach einem der Ansprüche 1 bis 5, wobei die flexible Leiterplatte (2, 16) zylindermantelförmige Gestalt besitzt.

8. Strommessvorrichtung (1) nach einem der vorhergehenden Ansprüche, die eine Kompensationselektronik auf oder an der flexiblen Leiterplatte (2, 16) besitzt.

9. Strommessvorrichtung (1) nach einem der vorhergehenden Ansprüche, die als einstückige Baugruppe realisiert ist.

10. Strommessvorrichtung (1) nach einem der vorhergehenden Ansprüche, wobei auf der Trägereinrichtung 6 bis 12 Magnetfeldsensoren (3) angeordnet sind.

FIG 1

## FIG 2

## FIG 3

FIG 4

FIG 5

# FIG 6

# FIG 7

# EP 3 561 524 A1

**Europäisches Patentamt**
**European Patent Office**
**Office européen des brevets**

## EUROPÄISCHER RECHERCHENBERICHT

**Nummer der Anmeldung**

EP 18 16 9290

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2018/046513 A1 (SIEMENS AG [DE]) 15. März 2018 (2018-03-15) * Seite 7, Zeile 23 - Seite 9, Zeile 14; Abbildungen 1-3 * ----- | 1-10 | INV. G01R15/20 |
| X | DE 10 2016 210970 A1 (SIEMENS AG [DE]) 21. Dezember 2017 (2017-12-21) * Absätze [0036], [0037]; Abbildungen 1,3,4 * ----- | 1,6,7 | |
| X | WO 2013/051566 A1 (ALPS GREEN DEVICES CO LTD [JP]) 11. April 2013 (2013-04-11) * Zusammenfassung; Abbildung 10 * ----- | 1-3 | |
| A | US 2007/114992 A1 (MUNIRAJU RAGHAVENDRA [IN] ET AL) 24. Mai 2007 (2007-05-24) * Absätze [0017], [0018], [0022], [0023], [0041] - Absatz [0048]; Abbildungen 1-3 * ----- | 5,8 | |
| A,D | WO 2016/156392 A1 (SIEMENS AG [DE]) 6. Oktober 2016 (2016-10-06) * Seite 8, Zeile 24 - Seite 12, Zeile 16; Abbildungen 2,3 * ----- | 5,8 | RECHERCHIERTE SACHGEBIETE (IPC) G01R |

Der vorliegende Recherchenbericht wurde für alle Patentansprüche erstellt

| Recherchenort | Abschlußdatum der Recherche | Prüfer |
|---|---|---|
| München | 28. September 2018 | Hof, Klaus-Dieter |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
......................................................................................................
& : Mitglied der gleichen Patentfamilie, übereinstimmendes
    Dokument

EPO FORM 1503 03.82 (P04C03)

12

## ANHANG ZUM EUROPÄISCHEN RECHERCHENBERICHT
## ÜBER DIE EUROPÄISCHE PATENTANMELDUNG NR.

EP 18 16 9290

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-09-2018

| Im Recherchenbericht angeführtes Patentdokument | Datum der Veröffentlichung | Mitglied(er) der Patentfamilie | Datum der Veröffentlichung |
|---|---|---|---|
| WO 2018046513 A1 | 15-03-2018 | DE 102016217168 A1<br>WO 2018046513 A1 | 15-03-2018<br>15-03-2018 |
| DE 102016210970 A1 | 21-12-2017 | KEINE | |
| WO 2013051566 A1 | 11-04-2013 | JP 5747212 B2<br>JP WO2013051566 A1<br>WO 2013051566 A1 | 08-07-2015<br>30-03-2015<br>11-04-2013 |
| US 2007114992 A1 | 24-05-2007 | US 2007114992 A1<br>WO 2007061832 A1 | 24-05-2007<br>31-05-2007 |
| WO 2016156392 A1 | 06-10-2016 | CN 107567589 A<br>DE 102015205794 A1<br>EP 3259603 A1<br>US 2018095112 A1<br>WO 2016156392 A1 | 09-01-2018<br>06-10-2016<br>27-12-2017<br>05-04-2018<br>06-10-2016 |

EPO FORM P0461

Für nähere Einzelheiten zu diesem Anhang : siehe Amtsblatt des Europäischen Patentamts, Nr.12/82

# EP 3 561 524 A1

## IN DER BESCHREIBUNG AUFGEFÜHRTE DOKUMENTE

### In der Beschreibung aufgeführte Patentdokumente

- WO 2016156392 A1

### In der Beschreibung aufgeführte Nicht-Patentliteratur

- **R. WEISS ; R. MAKUCH ; A. ITZKE ; R. WEIGEL.** Crosstalk in Circular Arrays of Magnetic Sensors for Current Measurement. *IEEE Transactions on Industrial Electronics,* Juni 2017, vol. 64 (6), 4903-4909

- **R. WEISS ; A. ITZKE ; R. WEIGEL.** Current measurement of flat conductors with a circular array of magnetic sensors. *IEEE Second International Conference on DC Microgrids (ICDCM),* 2017, 166-170